# EUROPEAN PATENT APPLICATION

(11) **EP 2 330 084 A1**
(43) Date of publication of application: **08.06.2011**
(21) Application number: 09811478.8
(22) Date of filing: 01.09.2009
(51) Int. Cl.: C03C 8/04, C03C 8/02, C03C 8/18, H01L 31/04

(54) **GLASS COMPOSITION FOR ELECTRODE FORMATION AND ELECTRODE FORMATION MATERIAL**

(30) Priority: 04.09.2008 JP 2008227083; 16.04.2009 JP 2009099687; 17.07.2009 JP 2009168331
(71) Applicant: Nippon Electric Glass Co., Ltd., Otsu-shi Shiga 520-8639 (JP)
(72) Inventor: ISHIHARA Kentaro, Otsu-shi Shiga 520-8639 (JP)
(74) Representative: Tetzner, Michael
(86) International application number: PCT/JP2009/065226
(87) International publication number: WO 2010/026952

(57) **Abstract**

Provided is a glass composition for electrode formation including, as a glass composition expressed in terms of oxides by mass%, 73.1 to 90% of Bi₂O₃, 2 to 14.5% of B₂O₃, 0 to 25% of ZnO, 0.2 to 20% of MgO+CaO+SrO+BaO (total content of MgO, CaO, SrO, and BaO), and 0 to 8.5% of SiO₂+Al₂O₃ (total content of SiO₂ and Al₂O₃).

## Description

### Technical Field

The present invention relates to a glass composition for electrode formation and an electrode formation material, and more particularly, to a glass composition for electrode formation and an electrode formation material suitable for forming a light-receiving surface electrode and a back-surface electrode of a silicon solar cell (including a monocrystalline silicon solar cell, a polycrystalline silicon solar cell, a microcrystalline silicon solar cell, and an amorphous silicon solar cell).

### Background Art

A silicon solar cell is provided with a semiconductor substrate, a light-receiving surface electrode, a back-surface electrode, and an anti-reflective film. The semiconductor substrate has a p-type semiconductor layer and an n-type semiconductor layer. The light-receiving surface electrode and the back-surface electrode are each formed by sintering an electrode formation material (including a metal powder, a glass powder, and a vehicle). In general, an Ag powder is used for the light-receiving surface electrode and an Al powder is used for the back-surface electrode. A silicon nitride film, a silicon oxide film, a titanium oxide film, an aluminum oxide film, or the like is used for the anti-reflective film. The silicon nitride film is mainly used at present.

There are exemplified a vapor deposition method, a plating method, and a printing method as a method of forming a light-receiving surface electrode in a silicon solar cell. The printing method has recently become mainstream. The printing method includes the steps of applying an electrode formation material onto an anti-reflective film or the like by screen printing, and then firing the electrode formation material at 650 to 850°C for a short time, to thereby form a light-receiving surface electrode.

In the case of the printing method, the phenomenon that the electrode formation material penetrates the anti-reflective film during the firing is taken advantage of to electrically connect the light-receiving surface electrode with a semiconductor layer. The phenomenon is generally called fire through. By taking advantage of the fire through, it becomes unnecessary to etch the anti-reflective film, and moreover, it becomes unnecessary to position an etching on the anti-reflective film with an electrode pattern, when the light-receiving surface electrode is formed. As a result, the production efficiency of the silicon solar cell improves dramatically.

Meanwhile, a back-surface electrode is usually formed by a thick-film method. The thick-film method includes the steps of screen printing an electrode formation material on a silicon semiconductor substrate so that a desired electrode pattern is formed, and firing the substrate at a maximum temperature of 660 to 900°C for a short time (specifically, for 2 to 3 minutes from the start of the firing to the finish and the maximum temperature is kept for 5 to 20 seconds), to thereby disperse Al on the silicon semiconductor substrate to form a back-surface electrode on a silicon semiconductor substrate.

The electrode formation material used for forming the back-surface electrode includes an Al powder, a glass powder, and a vehicle. When the electrode formation material is fired, the Al powder reacts with Si in the silicon semiconductor substrate, thereby forming anAl-Si alloy layer at the interface between the back-surface electrode and the silicon semiconductor substrate, and at the same time, forming a p+ electrolytic layer (back surface field layer, or also referred to as a BSF layer) at the interface between the Al-Si alloy layer and the silicon semiconductor substrate. The formation of the p+ electrolytic layer prevents the rebinding of electrons, thereby being able to provide an effect of improving efficiency in collecting carriers produced, that is, the so-called BSF effect. The formation of the p+ electrolytic layer can result in an increase in the photoelectric conversion efficiency of a silicon solar cell.

### Prior Art Document

### Patent Document

Patent Document 1: JP 2004-87951 A
Patent Document 2: JP 2005-56875 A
Patent Document 3: JP 2008-527698 A
Patent Document 4: JP 2000-90733 A
Patent Document 5: JP 2003-165744 A

### Summary of Invention

### Technical Problem

The degree of how much an electrode formation material for a light-receiving surface electrode penetrates an anti-reflective film (hereinafter, referred to as fire through property) varies depending on the composition of the electrode formation material and a firing condition, and in particular, is influenced most significantly by the glass composition of a glass powder. This is because the fire through is mainly caused by a reaction between the glass powder and the anti-reflective film. In addition, the photoelectric conversion efficiency of a silicon solar cell has a correlation with the fire through property of the electrode formation material. When the fire through property is poor, the characteristic lowers. As a result, the fundamental performance of the solar cell lowers.

Lead glass containing PbO as a main component has been conventionally used for a glass powder included in the electrode formation material for a light-receiving surface electrode. However, the lead glass was insufficient in water resistance, with the result that the long-term reliability of the silicon solar cell was easily damaged.

Further, the glass powder included in the electrode formation material for a light-receiving surface electrode is required to (1) have good fire through property, and moreover, to (2) have good thermal stability, (3) be able to be sintered at low temperatures, and the like.

Meanwhile, a glass powder included in an electrode formation material for a back-surface electrode has an action of imparting a BSF effect by promoting a reaction between an Al powder and Si to form a p+ electrolytic layer at the interface between an Al-Si alloy layer and a silicon semiconductor substrate (see Patent Documents 4 and 5).

However, when a conventional glass powder, to be specific, a lead borate-based glass powder is used, the reaction between an Al powder and Si becomes non-uniform, resulting in a local increase in the production amount of an Al-Si alloy. Then, a blister or aggregation of Al easily occurs on the surface of the back-surface electrode. As a result, the photoelectric conversion efficiency of the silicon solar cell lowers, and a crack or the like becomes likely to occur in the silicon semiconductor substrate in the production process of the silicon solar cell, and hence the production efficiency of the silicon solar cell lowers.

An object of the present invention is to create a glass composition that is more water-resistant than lead glass, has good fire through property and thermal stability, and can be sintered at low temperatures, to thereby enhance the photoelectric conversion efficiency and long-term reliability of the silicon solar cell.

Another object of the present invention is to create a glass composition for electrode formation and an electrode formation material which resist the occurrence of a blister or aggregation of Al and are suitable for forming the Al-Si alloy layer and the p+ electrolytic layer, thereby reducing the production cost of the silicon solar cell while enhancing the characteristics of the silicon solar cell, such as photoelectric conversion efficiency.

### Solution to Problem

The inventor of the present invention has made intensive studies. As a result, the inventor has found that the above-mentioned technical problems can be solved by using bismuth-based glass as glass for electrode formation and by controlling the glass composition of the bismuth-based glass in a predetermined range. Thus, the finding is proposed as the present invention. That is, a glass composition for electrode formation according to the present invention (first invention) includes, as a glass composition expressed in terms of oxides by mass%, 73.1 to 90% of Bi₂O₃, 2 to 14.5% of B₂O₃, 0 to 25% of ZnO, 0.2 to 20% of MgO+CaO+SrO+BaO (total content of MgO, CaO, SrO, and BaO), and 0 to 8.5% of SiO₂+Al₂O₃ (total content of SiO₂ and Al₂O₃).

In the glass composition for electrode formation of the present invention, the content of Bi₂O₃ is controlled at 73.1% or more. Thus, the reactivity between the glass powder and the anti-reflective film is enhanced, the fire through property is improved, and the softening point lowers. As a result, the electrode formation material can be sintered at low temperatures. Note that when the electrode is formed at low temperatures, the productivity of the silicon solar cell is improved and the release of hydrogen in the crystalline boundary of the semiconductor substrate becomes unlikely to occur, and hence the photoelectric conversion efficiency of the silicon solar cell is improved. Further, when the content of Bi₂O₃ is controlled at 73.1% or more, the water resistance is enhanced and the long-term reliability of the silicon solar cell can be enhanced. On the other hand, in the glass composition for electrode formation of the present invention, the content of Bi₂O₃ is controlled at 90% or less. Thus, glass becomes unlikely to devitrify during firing. As a result, the reactivity between the glass powder and the anti-reflective film becomes unlikely to lower and the sintering property of the electrode formation material becomes unlikely to lower.

In the glass composition for electrode formation of the present invention, the content of B₂O₃ is controlled at 2% or more. Thus, glass becomes unlikely to devitrify during firing. As a result, the reactivity between the glass powder and the anti-reflective film becomes unlikely to lower and the sintering property of the electrode formation material becomes unlikely to lower. On the other hand, in the glass composition for electrode formation of the present invention, the content of B₂O₃ is controlled at 14.5% or less. Thus, the softening point lowers, and hence the electrode formation material can be sintered at low temperatures. Moreover, the water resistance is enhanced, and hence the long-term reliability of the silicon solar cell can be enhanced.

In the glass composition for electrode formation of the present invention, the content of MgO+CaO+SrO+BaO is controlled at 0.2% or more. Thus, glass becomes unlikely to devitrify during firing. As a result, the reactivity between the glass powder and the anti-reflective film becomes unlikely to lower and the sintering property of the electrode formation material becomes unlikely to lower. On the other hand, in the glass composition for electrode formation of the present invention, the content of MgO+CaO+SrO+BaO is controlled at 20% or less. Thus, an unreasonable increase in the softening point can be suppressed, and hence the electrode formation material can be sintered at low temperatures.

In the glass composition for electrode formation of the present invention, the content of SiO₂+Al₂O₃ is controlled at 8.5% or less. Thus, the fire through property becomes unlikely to lower and the softening point of glass lowers, and hence the electrode formation material can be sintered at low temperatures. Note that in the glass composition for electrode formation of the present invention, the thermal stability of glass can be enhanced by adding ZnO in a glass composition.

In the above-mentioned configuration, the content of Bi₂O₃ may be set to 74.3% or more. Consequently, the effect described in the paragraph [0011] herein can be exhibited more significantly.

In the above-mentioned configuration, the content of BaO may be set to 0.2 to 15%. Out of alkaline-earth metal oxides, BaO exhibits most significantly an effect of enhancing the thermal stability without increasing the softening point. Thus, when the content of BaO is controlled in the above-mentioned range, the thermal stability can be enhanced while the increase of the softening point is suppressed.

The glass composition for electrode formation of the present invention may contain CuO. In that case, the content of CuO is preferably 2.5% or less. When an Ag powder is used as a metal powder, if CuO is contained in the glass composition of the glass powder in a large amount, Cu and an alloy containing Cu as a main component are precipitated during firing of the electrode formation material. As a result, the electrical resistance of the light-receiving surface electrode or the like becomes larger, and hence the cell characteristics of the silicon solar cell may lower. Thus, when the content of CuO is set to 2.5% or less, the situation described above can be prevented. However, when the content of CuO is smaller, glass becomes likely to devitrify during firing. Thus, when the content of CuO is reduced, it is effective that the content of ZnO is increased, thereby suppressing the reduction of thermal stability. For example, when the content of CuO is less than 0.1%, the content of ZnO is preferably more than 10%.

The electrode formation material of the present invention is characterized by including a glass powder including the above-mentioned glass composition for electrode formation according to the first invention, a metal powder, and a vehicle. Thus, an electrode pattern can be formed by a printing method and the production efficiency of the silicon solar cell can be enhanced. Here, the term "vehicle" generally refers to a substance obtained by dissolving a resin in an organic solvent. However, in the present invention, the term "vehicle" includes, as one aspect, a substance that does not contain a resin and is formed of only a highly viscous organic solvent (for example, a higher alcohol such as isotridecyl alcohol).

The electrode formation material of the present invention is characterized in that the glass powder has an average particle diameter D₅₀ of less than 5 µm in the above-mentioned configuration. Thus, the reactivity between the glass powder and the anti-reflective film is enhanced, the fire through property is improved, the softening point of the glass powder lowers, and hence the electrode formation material can be sintered at low temperatures. Further, as a result, a very fine electrode pattern can be formed. Note that when the very fine electrode pattern is formed, the amount of incident solar light or the like increases and the photoelectric conversion efficiency of the silicon solar cell is improved. Here, the phrase "average particle diameter D₅₀" refers to a particle diameter at which the cumulative amount of particles starting from a particle having the smallest diameter reaches 50% in a cumulative particle size distribution curve in terms of volume prepared based on the measurements by laser diffractometry.

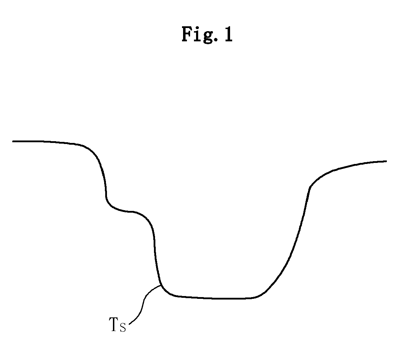

The electrode formation material of the present invention is characterized in that the glass powder has a softening point of 500°C or less in the above-mentioned configuration. Thus, the sintering property of the electrode formation material is improved. Here, the phrase "softening point" refers to a value obtained by measurement with a macro-type differential thermal analysis (DTA) apparatus, and in the DTA, the measurement starts from room temperature and the temperature rise rate is set to 10°C/min. Note that the softening point measured with the macro-type DTA apparatus refers to the temperature (Ts) at the fourth bending point illustrated in Fig. 1.

The electrode formation material of the present invention is characterized in that the glass powder has a crystallization temperature of 500°C or more in the above-mentioned configuration. Thus, the thermal stability of the glass powder is improved and glass becomes unlikely to devitrify during firing. As a result, the sintering property of the electrode formation material becomes unlikely to lower and the reactivity between the glass powder and the anti-reflective film becomes unlikely to lower. Here, the phrase "crystallization temperature" refers to a peak temperature measured with a macro-type DTA apparatus, and in the DTA, the measurement starts from room temperature and the temperature rise rate is set to 10°C/min.

The electrode formation material of the present invention is characterized in that the content of the glass powder is 0.2 to 10 mass% in the above-mentioned configuration. Thus, the conductivity of the electrodes can be enhanced while the sintering property of the electrode formation material is maintained.

The electrode formation material of the present invention is characterized in that the metal powder includes one kind of powder or two or more kinds of powders of Ag, Al, Au, Cu, Pd, Pt, and alloys thereof in the above-mentioned configuration. Any of those metal powders has good compatibility with the glass according to the present invention and has the property of preventing the easy bubbling of the glass during firing.

The electrode formation material of the present invention can be used for the electrodes of the silicon solar cell, and is particularly suitable for the light-receiving surface electrode of a silicon solar cell having an anti-reflective film.

Further, the inventor of the present invention has made intensive efforts. As a result, the inventor has found that the above-mentioned technical problems can be solved by using Bi₂O₃-B₂O₃-based glass and introducing a predetermined content of CuO+Fe₂O₃+Sb₂O₃+Nd₂O₃ (total content of CuO, Fe₂O₃, Sb₂O₃, and Nd₂O₃) in a glass composition. Thus, the finding is proposed as the present invention. That is, a glass composition for electrode formation according to the present invention (second invention) includes, as a glass composition expressed in terms of oxides by mass%, 60 to 90% of Bi₂O₃, 2 to 30% of B₂O₃, 0 to less than 3% of ZnO, and 0.1 to 15% of CuO+Fe₂O₃+Sb₂O₃+Nd₂O₃.

When Bi₂O₃ and B₂O₃ are introduced as main components of glass, the reaction between an Al powder and Si can be promoted, and hence the p+ electrolytic layer becomes likely to be formed. As a result, the BSF effect becomes likely to be provided and the photoelectric conversion efficiency of the silicon solar cell can be enhanced.

Further, when the content of ZnO is controlled in a range equal to or less than a predetermined range, a blister or aggregation of Al can be suppressed. When the content of CuO+Fe₂O₃+Sb₂O₃+Nd₂O₃ is introduced in a predetermined content, the thermal stability of glass is improved, and hence it becomes easy to prevent the situation in which the glass devitrifies during firing of the electrode formation material, so that the functions of the glass are not exerted. In other words, it becomes easy to prevent the situation in which the sintering property of the electrode formation material lowers, so that the mechanical strength of the back-surface electrode lowers, and the situation in which the reactivity between an Al powder and Si lowers, so that the BSF effect becomes unlikely to be provided. Consequently, when each of the contents of Bi₂O₃, B₂O₃, ZnO, and CuO+Fe₂O₃+Sb₂O₃+Nd₂O₃ is controlled in a predetermined range, the production cost of the silicon solar cell can be reduced while the characteristics of the silicon solar cell, such as photoelectric conversion efficiency, is enhanced.

The content of ZnO may be less than 1% in the above-mentioned configuration. Thus, the blister or aggregation of Al can be remarkably suppressed.

The glass composition may be substantially free of ZnO in the above-mentioned configuration. Here, the phrase "substantially free of ZnO" refers to the case where the content of ZnO in a glass composition is 1000 ppm or less.

The glass composition for electrode formation of the present invention may contain alkali metal oxides. In that case, the content of the alkali metal oxides is preferably 0.05% or more.

Further, the glass composition for electrode formation of the present invention may contain SiO₂. In that case, the content of SiO₂ is preferably less than 3%. Thus, it becomes easy to prevent the situation in which the softening point of glass unreasonably increases, or the situation in which the thermal stability of glass lowers and the glass devitrifies during firing of the electrode formation material.

The electrode formation material of the present invention is characterized by including a glass powder including the above-mentioned glass composition for electrode formation according to the second invention, a metal powder, and a vehicle. Thus, an electrode pattern can be formed by a thick-film method, and hence the production efficiency of the silicon solar cell can be enhanced. Here, the term "vehicle" generally refers to a substance obtained by dissolving a resin in an organic solvent. However, in the present invention, the term "vehicle" includes, as one aspect, a substance that does not contain a resin and is formed of only a highly viscous organic solvent (for example, a higher alcohol such as isotridecyl alcohol).

The electrode formation material of the present invention is characterized in that the glass powder has an average particle diameter D₅₀ of less than 5 µm in the above-mentioned configuration. Here, the phrase "average particle diameter D₅₀" refers to a value obtained by measurement by laser diffractometry, and refers to a particle diameter at which the cumulative amount of particles starting from a particle having the smallest diameter reaches 50% in a cumulative particle size distribution curve in terms of volume prepared based on the measurements by the laser diffractometry.

The electrode formation material of the present invention is characterized in that the glass powder has a softening point of 600°C or less in the above-mentioned configuration. Thus, the back-surface electrode can be formed at low temperatures. Here, the phrase "softening point" refers to a value obtained by measurement with a macro-type differential thermal analysis (DTA) apparatus, and in the DTA, the measurement starts from room temperature and the temperature rise rate is set to 10°C/min. Note that the softening point measured with the macro-type DTA apparatus refers to the temperature (Ts) at the fourth bending point illustrated in Fig. 1.

The electrode formation material of the present invention is characterized in that the content of the glass powder is 0.2 to 10 mass% in the above-mentioned configuration. Thus, the p+ electrolytic layer is formed at the interface between an Al-Si alloy layer and a silicon semiconductor substrate and the BSF effect becomes likely to be provided.

The electrode formation material of the present invention is characterized in that the metal powder includes one kind of powder or two or more kinds of powders of Ag, Al, Au, Cu, Pd, Pt, and alloys thereof in the above-mentioned configuration. Any of those metal powders has good compatibility with the glass powder according to the present invention and has the property of preventing the easy bubbling of glass during firing of the electrode formation material.

The electrode formation material of the present invention is characterized in that the metal powder includes an Al powder in the above-mentioned configuration.

The electrode formation material of the present invention can be used for the electrodes of the silicon solar cell, and is particularly suitable for the back-surface electrode of the silicon solar cell.

### Brief Description of Drawings

[Fig. 1] Fig. 1 is a schematic view showing a softening point of a glass powder obtained by measurement with a macro-type DTA apparatus.

### Description of Embodiments

The reasons why the content ranges of respective components were defined to those described above in a glass composition for electrode formation of the present invention (first invention) are described below. Note that unless otherwise specified, "%" described below refers to mass%.

Bi₂O₃ is a component that enhances the water resistance and the fire through property and a component that lowers the softening point. The content of Bi₂O₃ is 73.1 to 90%, preferably 74.3 to 86%, more preferably 75 to 86%, or still more preferably 76 to 82%. When the content of Bi₂O₃ is too large, glass is liable to devitrify during firing. As a result of the devitrification, the reactivity between a glass powder and an anti-reflective film and the sintering property of an electrode formation material are liable to lower. On the other hand, when the content of Bi₂O₃ is too small, the water resistance and the fire through property lower, and moreover, the softening point becomes too high. As a result, it becomes difficult to sinter the electrode formation material at low temperatures.

B₂O₃ is an essential component as a glass-forming component. The content of B₂O₃ is 2 to 14.5%, preferably 4 to 12%, or more preferably 6 to 10.5%. When the content of B₂O₃ is too small, a glass network becomes unlikely to be formed, and hence glass becomes likely to devitrify during firing. As a result of the devitrification, the reactivity between the glass powder and the anti-reflective film and the sintering property of the electrode formation material are liable to lower. On the other hand, when the content of B₂O₃ is too large, the viscosity of glass tends to be high, it becomes difficult to sinter the electrode formation material at low temperatures, and moreover, the water resistance is liable to lower. As a result, the long-term reliability of a silicon solar cell is liable to lower.

ZnO is a component that improves the thermal stability and is also a component that lowers the softening point without lowering the thermal expansion coefficient. The content of ZnO is 0 to 25%, preferably 1 to 16%, or more preferably 5 to 12%. When the content of ZnO is too large, the balance of components in a glass composition is lost, with the result that crystals are liable to precipitate in glass to the worse. Note that from the viewpoint of surely improving the thermal stability of glass, the content of ZnO is preferably 3% or more. Further, when the content of CuO is less than 0.1%, the content of ZnO is preferably more than 10%.

MgO+CaO+SrO+BaO are components that enhance the thermal stability. The content of MgO+CaO+SrO+BaO is 0.2 to 20%, 1 to 15%, or particularly preferably 3 to 10%. When the total content of MgO+CaO+SrO+BaO is more than 20%, the softening point becomes too high, and hence it becomes difficult to sinter the electrode formation material at low temperatures. Further, the content of MgO is 0 to 5% or particularly preferably 0 to 2%. The content of CaO is 0 to 5% or particularly preferably 0 to 2%. The content of SrO is 0 to 6% or particularly preferably 0 to 3%.

Out of the alkaline-earth metal oxides, BaO exhibits an effect of enhancing the thermal stability most significantly, and moreover, has an effect of resisting the increase of the softening point, and hence it is preferred that BaO be positively contained in a glass composition. The content of BaO is 0 to 15%, 0.2 to 10%, 1 to 9%, or particularly preferably 4 to 9%. When the content of BaO is more than 15%, the balance of components in a glass composition is lost, with the result that the thermal stability becomes likely to lower to the worse.

SiO₂+Al₂O₃ are components that enhance the water resistance. However, SiO₂+Al₂O₃ are components that lower the fire through property, and in addition, have an action of increasing the softening point remarkably. Thus, the content of SiO₂+Al₂O₃ is 8.5% or less, preferably 5% or less, 3% or less, or particularly preferably less than 1%. Further, when the content of SiO₂+Al₂O₃ is more than 8.5%, the fire through property lowers, and moreover, the softening point becomes too high, with the result that it becomes difficult to sinter the electrode formation material at low temperatures. Note that the content of SiO₂ is 4% or less, 3% or less, 2% or less, or particularly preferably less than 1%. Further, the content of Al₂O₃ is 5% or less, 3% or less, 2% or less, or particularly preferably less than 1%.

The glass composition for electrode formation of the present invention may also contain the following components at up to 20% in addition to the above-mentioned components.

Cu+Fe₂O₃ (total content of Cu and Fe₂O₃) are components that enhance the thermal stability. The content of Cu+Fe₂O₃ is 0 to 15%, 0.1 to 10%, or particularly preferably 1 to 10%. When the content of Cu+Fe₂O₃ is more than 15%, the balance of components in a glass composition is lost, with the result that the precipitation rate of crystals becomes fast, that is, the thermal stability tends to lower. In order to enhance the fire through property, Bi₂O₃ is required to be added in a large content in a glass composition. However, when the content of Bi₂O₃ is increased, glass becomes likely to devitrify during firing. As a result of the devitrification, the reactivity between the glass powder and the anti-reflective film becomes likely to lower. In particular, when the content of Bi₂O₃ becomes 75% or more, the tendency becomes remarkable. Thus, when Cu+Fe₂O₃ are added in a glass composition in an appropriate content, the devitrification of glass can be suppressed even if the content of Bi₂O₃ is 75% or more. Note that as described above, the content of CuO is preferably as small as possible, to be specific, 4% or less, 2.5% or less, 2% or less, or ideally less than 0.1%, from the viewpoint of preventing the precipitation of Cu and its alloys. Further, the content of Fe₂O₃ is 0 to 10%, 0.05 to 5%, or particularly preferably 0.2 to 3%.

Li₂O, Na₂O, K₂O, and Cs₂O are components that lower the softening point. Those components have an effect of promoting the devitrification of glass at during melting, and hence the content of each of those components is preferably 2% or less.

Sb₂O₃ is a component that enhances the thermal stability. The content of Sb₂O₃ is 0 to 7% or particularly preferably 0.1 to 3%. When the content of Sb₂O₃ is too large, the balance of components in a glass composition is lost, with the result that the thermal stability becomes likely to lower to the worse. Note that the use of Sb₂O₃ is restricted in some cases from the viewpoint of environment. In that case, the glass composition is preferably substantially free of Sb₂O₃. Here, the phrase "substantially free of Sb₂O₃" refers to the case where the content of Sb₂O₃ in a glass composition is 1000 ppm or less.

Nd₂O₃ is a component that enhances the thermal stability. The content of Nd₂O₃ is 0 to 10%, 0 to 5%, or particularly preferably 0.1 to 3%. When Nd₂O₃ is added in a glass composition in a predetermined content, the glass network of Bi₂O₃-B₂O₃ is stabilized. As a result, crystals of Bi₂O₃ (bismite) or crystals of 2Bi₂O₃-B₂O₃, 12Bi₂O₃·B₂O₃, or the like formed of Bi₂O₃ and B₂O₃ become unlikely to precipitate during firing. Note that when the content of Nd₂O₃ is too large, the balance of components in a glass composition is lost, with the result that the crystals are liable to precipitate in glass to the worse.

W₃ is a component that enhances the thermal stability. The content of WO₃ is 0 to 5% or particularly preferably 0 to 2%. When the content of WO₃ is too large, the balance of components in a glass composition is lost, with the result that the thermal stability becomes likely to lower to the worse.

In₂O₃+Ga₂O₃ (total content of In₂O₃ and Ga₂O₃) are components that enhance the thermal stability. The content of In₂O₃+Ga₂O₃ is 0 to 5%, 0 to 3%, or particularly preferably 0 to 1%. When the content of In₂O₃+Ga₂O₃ is too large, the balance of components in a glass composition is lost, with the result that the thermal stability becomes likely to lower to the worse. Note that the content of each of In₂O₃ and Ga₂O₃ is preferably 0 to 2%.

P₂O₅ is a component that suppresses the devitrification of glass during melting. However, when the content of P₂O₅ is large, the phase separation of glass becomes likely to occur during melting. Thus, the content of P₂O₅ is preferably 1% or less.

MoO₃+La₂O₃+Y₂O₃+ceO₂ (total content of MoO₃, La₂O₃, Y₂O₃, and CeO₂) have an effect of suppressing the phase separation during melting. However, when the content of those components is large, the softening point becomes too high, and hence it becomes difficult to sinter the electrode formation material at low temperatures. Thus, the content of MO₃+La₂O₃+Y₂O₃+ceO₂ is preferably 3% or less. Note that the content of each of MoO₃, La₂O₃, Y₂O₃, and CeO₂ is preferably 0 to 2%.

It is not eliminated that the bismuth-based glass composition of the present invention contains PbO, but the bismuth-based glass composition is preferably substantially free of PbO from the viewpoint of environment. Further, as PbO has insufficient water resistance, the bismuth-based glass composition is preferably substantially free of PbO when the bismuth-based glass composition is used for the silicon solar cell. Here, the phrase "substantially free of PbO" refers to the case where the content of PbO in a glass composition is 1000 ppm or less.

The electrode formation material of the present invention includes a glass powder including the above-mentioned glass composition for electrode formation, a metal powder, and a vehicle. The glass powder is a component that causes the fire through of the electrode formation material by eroding the anti-reflective film during firing and is also a component that bonds an electrode to a semiconductor substrate. The metal powder is a main component forming electrodes and a component for securing conductivity. The vehicle is a component for converting the electrode formation material into a paste state and a component for imparting viscosity suitable for printing.

In the electrode formation material of the present invention, the average particle diameter D₅₀ of the glass powders is less than 5 µm, 4 µm or less, 3 µm or less, 2 µm or less, or particularly preferably 1.5 µm or less. When the average particle diameter D₅₀ of the glass powders is 5 µm or more, the surface areas of the glass powders become small. Because of this fact, the reactivity between the glass powder and the anti-reflective film lowers and the fire throughpropertybecomes likely to lower. Further, when the average particle diameter D₅₀ of the glass powders is 5 µm or more, the softening point of the glass powders rises and the region of the temperatures necessary for forming the electrodes rises. Moreover, when the average particle diameter D₅₀ of the glass powders is 5 µm or more, forming a fine electrode pattern becomes difficult, and hence the photoelectric conversion efficiency of the silicon solar cell becomes likely to lower. On the other hand, although the lower limit of the average particle diameter D₅₀ of the glass powders is not particularly limited, when the average particle diameter D₅₀ of the glass powders is too small, the ease of handling the glass powders lowers and the material yield of the glass powders lowers. In addition to those, the glass powders are liable to aggregate, and hence the characteristics of the silicon solar cell are liable to vary. When the circumstances described above are taken into consideration, the average particle diameter D₅₀ of the glass powders is 0.1 µm or more, 0.3 µm or more, or particularly preferably 0.5 µm or more. Note that (1) when a glass film is pulverized in a ball mill and the resultant glass powder is then subjected to air classification, or (2) when a glass film is roughly pulverized in a ball mill or the like and the resultant glass is then subjected to wet pulverization in a bead mill or the like, the glass powders having the above-mentioned average particle diameter D₅₀ can be obtained.

In the electrode formation material of the present invention, the maximum particle diameter Dₘₐₓ of the glass powders is 25 µm or less, 20 µm or less, 15 µm or less, or particularly preferably 10 µm or less. When the maximum particle diameter Dₘₐₓ of the glass powders is more than 25 µm, forming a fine electrode pattern becomes difficult, and hence the photoelectric conversion efficiency of the silicon solar cell becomes likely to lower. Here, the phrase "maximum particle diameter Dₘₐₓ" refers to a particle diameter at which the cumulative amount of particles starting from a particle having the smallest diameter reaches 99% in a cumulative particle size distribution curve in terms of volume prepared based on the measurements by laser diffractometry.

In the electrode formation material of the present invention, the softening point of the glass powder is 500°C or less, 480°C or less, or particularly preferably 400 to 460°C. When the softening point of the glass powder is more than 500°C, the region of the temperatures necessary for forming the electrodes rises. Note that when the softening point of the glass powder is less than 400°C, the reaction between the glass powder and the anti-reflective film progresses excessively, and hence the glass powder also erodes the semiconductor substrate. As a result, the cell characteristics of the solar cell may lower.

In the electrode formation material of the present invention, the crystallization temperature of the glass powder is 500°C or more, 550°C or more, 600°C or more, 620°C or more, or particularly preferably 650°C or more. When the crystallization temperature of the glass powder is less than 500°C, the thermal stability of the glass powder lowers, and hence glass becomes likely to devitrify before the glass powder reacts with the anti-reflective film during firing. As a result of the devitrification, the reactivity between the glass powder and the anti-reflective film and the sintering property of the electrode formation material are liable to lower.

In the electrode formation material of the present invention, the content of the glass powder is 0.2 to 10 mass%, 1 to 6 mass%, or particularly preferably 1.5 to 4 mass%. When the content of the glass powder is less than 0.2 mass%, the sintering property of the electrode formation material becomes likely to lower. On the other hand, when the content of the glass powder is more than 10 mass%, the conductivity of the electrodes formed lowers. As a result, it becomes difficult to extract electricity generated. Further, because of the same reasons as those described above, the mass ratio of the content between the glass powder and the metal powder is 0.3:99.7 to 13:87, 1.5:98.5 to 7.5:92.5, or particularly preferably 2:98 to 5:95.

In the electrode formation material of the present invention, the content of the metal powder is 50 to 97 mass%, 65 to 95 mass%, or particularly preferably 70 to 92 mass%. When the content of the metal powder is less than 50 mass%, the conductivity of the electrodes formed lowers. As a result, the photoelectric conversion efficiency of the silicon solar cell becomes likely to lower. On the other hand, when the content of the metal powder is more than 97 mass%, there is no other way but to relatively lower the content of the glass powder, and hence the sintering property of the electrode formation material becomes likely to lower.

In the electrode formation material of the present invention, the metal powder preferably includes one kind of powder or two or more kinds of powders of Ag, Al, Au, Cu, Pd, Pt, and alloys thereof, or more preferably includes the powder of Ag or Al. Any of those metal powders has good conductivity and has good compatibility with the glass powder according to the present invention. When any of those metal powders is used, glass thus becomes unlikely to devitrify, and moreover, glass becomes unlikely to produce bubbles during firing. Further, in order to form a fine electrode pattern, the average particle diameter D₅₀ of the metal powders is 3.5 µm or less, 2 µm or less, or particularly preferably 1 µm or less.

In the electrode formation material of the present invention, the content of the vehicle is 5 to 40 mass% or particularly preferably 10 to 25 mass%. When the content of the vehicle is less than 5 mass%, converting the electrode formation material into a paste state becomes difficult, and hence it becomes difficult to form the electrodes by a printing method. On the other hand, when the content of the vehicle is more than 40 mass%, film thickness and film width are liable to vary before and after firing. As a result, it becomes difficult to form a desired electrode pattern.

As described above, the term "vehicle" generally refers to a substance obtained by dissolving a resin in an organic solvent. Examples of the resin which may be used include an acrylic acid ester (acrylic resin), ethylcellulose, a polyethylene glycol derivative, nitrocellulose, polymethylstyrene, polyethylene carbonate, and a methacrylic acid ester. In particular, an acrylic acidester, nitrocellulose, and ethylcellulose are preferred because of good thermolytic property. Examples of the organic solvent which may be used include N,N'-dimethylformamide (DMF), α-terpineol, a higher alcohol, γ-butyrolactone (γ-BL), tetralin, butyl carbitol acetate, ethyl acetate, isoamyl acetate, diethylene glycol monoethyl ether, diethylene glycol monoethyl ether acetate, benzyl alcohol, toluene, 3-methoxy-3-methylbutanol, water, triethylene glycol monomethyl ether, triethylene glycol dimethyl ether, dipropylene glycol monomethyl ether, dipropylene glycol monobutyl ether, tripropylene glycol monomethyl ether, tripropylene glycol monobutyl ether, propylene carbonate, dimethyl sulfoxide (DMSO), and N-methyl-2-pyrrolidone. In particular, α-terpineol is preferred because of high viscosity and good solubility for a resin and the like.

The electrode formation material of the present invention may contain, in addition to the above-mentioned components, a ceramic filler powder such as cordierite for adjusting the thermal expansion coefficient, an oxide powder such as an NiO powder for adjusting the resistance of the electrodes, a surfactant or a thickener for adjusting the paste characteristic, a pigment for adjusting the outer appearance quality, and the like.

The electrode formation material of the present invention is appropriate in the reactivity with a silicon nitride film, a silicon oxide film, a titanium oxide film, and an aluminum oxide film, and is particularly appropriate in the reactivity with the silicon nitride film and is excellent in fire through property. As a result, the electrode formation material can penetrate the anti-reflective film during firing, and hence the light-receiving surface electrode of the silicon solar cell can be efficiently formed.

The electrode formation material of the present invention is also suitable for forming the back-surface electrode of the silicon solar cell. An electrode formation material for forming a back-surface electrode usually includes an Al powder, a glass powder, a vehicle, and the like. The back-surface electrode is usually formed by the above-mentioned printing method. The electrode formation material of the present invention can promote a reaction that an Al powder reacts with Si in a semiconductor substrate, thereby forming an Al-Si alloy layer at the interface between the back-surface electrode and the semiconductor substrate, and can also promote the formation of a p+ electrolytic layer (back surface field layer, or also referred to as a BSF layer) at the interface between the Al-Si alloy layer and the semiconductor substrate. The formation of the p+ electrolytic layer prevents the recombination of electrons, thereby being able to provide an effect of enhancing efficiency in collecting carriers produced, that is, the so-called BSF effect. As a result, the formation of the p+ electrolytic layer can lead to enhancement of the photoelectric conversion efficiency of the silicon solar cell. Further, when the electrode formation material of the present invention is used, the following failures can be properly prevented. That is, when the electrode formation material of the present invention is used, it is possible to prevent a failure that the reaction between an Al powder and Si becomes non-uniform, resulting in a local increase in the production amount of an Al-Si alloy, and because of the phenomenon, a blister or aggregation of Al occurs on the surface of the back-surface electrode, resulting in reduction in the photoelectric conversion efficiency of the silicon solar cell. Further, it is also possible to prevent a failure that a crack or the like occurs in a silicon semiconductor substrate in the production process of the silicon solar cell, and hence the production efficiency of the silicon solar cell lowers.

Next, the reasons why the content ranges of respective components were defined to those described above in a glass composition for electrode formation of the present invention (second invention) are described below.

Bi₂O₃ is a component that forms the skeleton of glass, a component that promotes the reaction between an Al powder and Si, and a component that lowers the softening point. The content of Bi₂O₃ is 60 to 90%, preferably 67 to 86%, more preferably 71 to 86%, or still more preferably 75 to 82.5%. When the content of Bi₂O₃ is larger, the thermal stability of glass lowers. As a result, when an electrode formation material is fired, glass becomes likely to devitrify and the mechanical strength of a back-surface electrode becomes likely to lower. On the other hand, when the content of Bi₂O₃ is smaller, the reaction between an Al powder and Si becomes likely to be non-uniform, resulting in a local increase in the production amount of an Al-Si alloy, and a blister or aggregation of Al becomes likely to occur. Further, when the content of Bi₂O₃ is smaller, the softening point of glass becomes too high, and hence forming the back-surface electrode at low temperatures becomes difficult.

B₂O₃ is a component that forms the skeleton of glass and a component that promotes the reaction between an Al powder and Si. Further, B₂O₃ is a component that enhances the thermal stability of glass and a component that lowers the softening point of glass. The content of B₂O₃ is 2 to 30%, preferably 5 to 25%, or more preferably 10 to 20%. When the content of B₂O₃ is smaller, the reaction between an Al powder and Si becomes likely to be non-uniform, resulting in the local increase in the production amount of the Al-Si alloy, and the blister or aggregation of Al becomes likely to occur. Further, when the content of B₂O₃ is smaller, the thermal stability of glass lowers. As a result, when the electrode formation material is fired, glass becomes likely to devitrify and the mechanical strength of the back-surface electrode becomes likely to lower. On the other hand, when the content of B₂O₃ is larger, the water resistance of glass becomes likely to lower. As a result, the long-term reliability of the back-surface electrode lowers, and moreover, the phase separation of glass becomes likely to occur, with the result that it becomes difficult to form uniformly an Al-Si alloy layer and a p+ electrolytic layer.

ZnO is a component that enhances the thermal stability of glass and is also a component that lowers the softening point of glass without increasing the thermal expansion coefficient of glass. However, when the content of ZnO is larger, the reaction between an Al powder and Si becomes likely to be non-uniform, resulting in the local increase in the production amount of the Al-Si alloy, and the blister or aggregation of Al becomes likely to occur. Thus, the content of ZnO is 0 to less than 3% or preferably 0 to less than 1%. Ideally, it is desirable that the glass composition for electrode formation be substantially free of ZnO.

CuO+Fe₂O₃+Sb₂O₃+Nd₂O₃ are components that enhance the thermal stability. The content of CuO+Fe₂O₃+Sb₂O₃+Nd₂O₃ is 0.1 to 15%, preferably 0.5 to 10%, or more preferably 1 to 8%. When the content of CuO+Fe₂O₃+Sb₂O₃+Nd₂O₃ is more than 15%, the balance of components in a glass composition is lost, with the result that the thermal stability of glass tends to lower to the worse. In order to provide a BSF effect properly, it is necessary to add Bi₂O₃ in a large content in a glass composition. However, when the content of Bi₂O₃ is increased, glass becomes likely to devitrify during firing of the electrode formation material. As a result of the devitrification, the mechanical strength of the back-surface electrode becomes likely to lower. In particular, when the content of Bi₂O₃ is 75% or more, the tendency becomes remarkable. Thus, when CuO+Fe₂O₃+Sb₂O₃+Nd₂O₃ are added in an appropriate content in a glass composition, the devitrification of glass can be suppressed even if the content of Bi₂O₃ is 75% or more. The content of CuO is 0 to 15%, 0.1 to 10%, or particularly preferably 1 to 5%. Further, the content of Fe₂O₃ is 0 to 10%, 0.05 to 5%, or particularly preferably 0.2 to 3%. Further, the content of Sb₂O₃ is 0 to 7% or particularly preferably 0.1 to 3%. Note that the use of Sb₂O₃ is restricted in some cases from the viewpoint of environment. In that case, the glass composition is preferably substantially free of Sb₂O₃. Here, the phrase "substantially free of Sb₂O₃" refers to the case where the content of Sb₂O₃ in a glass composition is 1000 ppm or less. The content of Nd₂O₃ is 0 to 10%, 0 to 5%, or particularly preferably 0.1 to 3%. Note that when Nd₂O₃ is added in a predetermined content in a glass composition, the glass network of Bi₂O3-B₂O₃-based glass is stabilized. As a result, crystals of Bi₂O₃ (bismite) or crystals of 2Bi₂O₃·B₂O₃, 12Bi₂O₃·B₂O₃, or the like formed of Bi₂O₃ and B₂O₃ become unlikely to precipitate during firing.

The glass composition for electrode formation of the present invention may also contain, for example, the following components at up to 25% or preferably up to 10% in total content in addition to the above-mentioned components.

Alkali metal oxides (total content of Li₂O, Na₂O, K₂O, and Cs₂O) are components that lower the softening point and are components that promote the sintering property of the electrode formation material. The total content of the alkali metal oxides is 0 to 15%, 0.05 to 5%, or particularly preferably 0.1 to 2%. When the content of the alkali metal oxides is larger, the thermal stability of glass lowers, and hence glass becomes likely to devitrify during melting or firing. Note that the content of each of Li₂O, Na₂O, K₂O, and Cs₂O is 0 to 5% or particularly preferably 0.1 to 2%.

MgO+CaO+SrO+BaO (total content of MgO, CaO, SrO, and BaO) are components that suppress the blister or aggregation of Al. The content of MgO+CaO+SrO+BaO is 0.01 to 20%, 0.1 to 20%, 1 to 15%, or particularly preferably 3 to 10%. When the content of MgO+CaO+SrO+BaO is smaller, the reaction between an Al powder and Si becomes likely to be non-uniform, resulting in the local increase in the production amount of the Al-Si alloy, and the blister or aggregation of Al becomes likely to occur. On the other hand, when the content of MgO+CaO+SrO+BaO is larger, it becomes difficult to form the p+ electrolytic layer. As a result, providing the BSF effect becomes difficult and the photoelectric conversion efficiency of the silicon solar cell becomes likely to lower. Further, when the content of MgO+CaO+SrO+BaO is larger, the balance of components in a glass composition is lost, with the result that crystals are liable to precipitate in glass to the worse.

MgO is a component that suppresses the blister or aggregation of Al. The content of MgO is 0 to 5%, 0.1 to 3%, or particularly preferably 0 to 1%. When the content of MgO is larger, it becomes difficult to form the p+ electrolytic layer. As a result, providing the BSF effect becomes difficult and the photoelectric conversion efficiency of the silicon solar cell becomes likely to lower.

CaO is a component that has a high effect of suppressing the blister or aggregation of Al. The content of CaO is 0 to 20%, 0.01 to 10%, 0.1 to 8%, 0.5 to 5%, or particularly preferably 1 to 4%. When the content of CaO is smaller, the reaction between an Al powder and Si becomes likely to be non-uniform, resulting in the local increase in the production amount of the Al-Si alloy, and the blister or aggregation of Al becomes likely to occur. On the other hand, when the content of CaO is larger, it becomes difficult to form the p+ electrolytic layer. As a result, providing the BSF effect becomes difficult and the photoelectric conversion efficiency of the silicon solar cell becomes likely to lower.

SrO is a component that suppresses the blister or aggregation of Al and a component that enhances the thermal stability of glass. The content of SrO is 0 to 15%, 0 to 10%, or particularly preferably 0 to 5%. When the content of SrO is larger, it becomes difficult to form the p+ electrolytic layer. As a result, providing the BSF effect becomes difficult and the photoelectric conversion efficiency of the silicon solar cell becomes likely to lower. Further, when the content of SrO is larger, the balance of components in a glass composition is lost, with the result that crystals are liable to precipitate in glass to the worse.

BaO is a component that suppresses the blister or aggregation of Al and a component that enhances the thermal stability of glass. The content of BaO is 0 to 20%, 0.01 to 15%, 0.1 to 12%, 1 to 10%, or particularly preferably 3 to 9%. When the content of BaO is smaller, the reaction between an Al powder and Si becomes likely to be non-uniform, resulting in the local increase in the production amount of the Al-Si alloy, and the blister or aggregation of Al becomes likely to occur. On the other hand, when the content of BaO is larger, it becomes difficult to form the p+ electrolytic layer. As a result, providing the BSF effect becomes difficult and the photoelectric conversion efficiency of the silicon solar cell becomes likely to lower. Further, when the content of BaO is larger, the balance of components in a glass composition is lost, with the result that crystals are liable to precipitate in glass to the worse.

SiO₂ is a component that enhances the water resistance of glass. However, as SiO₂ has an action of remarkably increasing the softening point of glass, the content of SiO₂ is 25% or less, 8.5% or less, less than 3%, or particularly preferably less than 1%. When the content of SiO₂ is larger, the softening point of glass becomes too high, and hence forming the back-surface electrode at low temperatures becomes easy.

WO₃ is a component that enhances the thermal stability. The content of WO₃ is 0 to 5% or particularly preferably 0 to 2%. When the content of WO₃ is too large, the balance of components in a glass composition is lost, with the result that the thermal stability of glass becomes likely to lower to the worse.

In₂O₃+Ga₂O₃ (total content of In₂O₃ and Ga₂O₃) are components that enhance the thermal stability of glass. The content of In₂O₃+Ga₂O₃ is 0 to 5%, 0 to 3%, or particularly preferably 0 to 1%. When the content of In₂O₃+Ga₂O₃ is too large, the balance of components in a glass composition is lost, with the result that the thermal stability becomes likely to lower to the worse. Note that the content of each of In₂O₃ and Ga₂O₃ is preferably 0 to 2%.

P₂O₅ is a component that suppresses the devitrification of glass during melting. However, when the content of P₂O₅ is large, the phase separation of glass becomes likely to occur during melting, and hence it becomes difficult to form the Al-Si alloy layer and the p+ electrolytic layer uniformly. Thus, the content of P₂O₅ is preferably 1% or less.

MoO₃+La₂O₃+Y₂O₃+ceO₂ (total content of MoO₃, La₂O₃, Y₂O₃, and CeO₂) have an effect of suppressing the phase separation of glass during melting. However, when the content of those components is large, the softening point of glass becomes too high, and hence it becomes difficult to sinter the electrode formation material at low temperatures. Thus, the content of MoO₃+La₂O₃+Y₂O₃+CeO₂ is preferably 3% or less. Note that the content of each of MoO₃, La₂O₃, Y₂O₃, and CeO₂ is preferably 0 to 2%.

It is not eliminated that the glass composition for electrode formation of the present invention contains PbO, but the glass composition for electrode formation is preferably substantially free of PbO from the viewpoint of environment. Further, as PbO easily encourages the blister or aggregation of Al, the glass composition for electrode formation is preferably substantially free of PbO when the glass composition for electrode formation is used for the formation of the back-surface electrode of the silicon solar cell. Here, the phrase "substantially free of PbO" refers to the case where the content of PbO in a glass composition is 1000 ppm or less.

In the glass composition for electrode formation of the present invention, the thermal expansion coefficient is 130×10⁻⁷/°C or less, 110×10⁻⁷/°C or less, 105×10⁻⁷/°C or less, or particularly preferably less than 100×10⁻⁷/°C. In recent years, studies have been made on how to produce a thinner silicon semiconductor substrate in order to reduce the production cost of a silicon solar cell. When the thickness of a silicon semiconductor substrate becomes thinner, such warpage that a back surface side on which a back-surface electrode is formed has a concave shape becomes likely to occur in the silicon semiconductor substrate, after an electrode formation material is fired, because the thermal expansion coefficient is different between Al and the silicon semiconductor substrate. Thus, when the thermal expansion coefficient is set to the above-mentioned range, the warpage of the silicon semiconductor substrate can be suppressed to the lowest possible extent. Note that the phrase "thermal expansion coefficient" refers to a value obtained by measurement with a push-rod-type thermomechanical analysis (TMA) apparatus, and refers to a value obtained by measurement in the temperature range of 30 to 300°C.

The electrode formation material of the present invention includes a glass powder including the above-mentioned glass composition for electrode formation according to the second invention, a metal powder, and a vehicle. The glass powder is a component that promotes the reaction between an Al powder and Si and forms a p+ electrolytic layer at the interface between an Al-Si alloy layer and a silicon semiconductor substrate, thereby imparting a BSF effect. The metal powder is a main component forming an electrode and a component for securing conductivity. The vehicle is a component for converting the electrode formation material into a paste state and a component for imparting viscosity suitable for printing.

In the electrode formation material of the present invention, the average particle diameter D₅₀ of the glass powders is less than 5 µm, 4 µm or less, 3 µm or less, 2 µm or less, 1 µm or less, or particularly preferably less than 1 µm. When the average particle diameter D₅₀ of the glass powders is 5 µm or more, the surface areas of the glass powders become small. Because of this fact, promoting the reaction between an Al powder and Si becomes difficult and imparting the BSF effect becomes difficult. Further, when the average particle diameter D₅₀ of the glass powders is 5 µm or more, the softening point of the glass powders rises and the region of the temperatures necessary for forming the electrodes rises. Moreover, when the average particle diameter D₅₀ of the glass powders is 5 µm or more, forming a fine electrode pattern becomes difficult, and hence the photoelectric conversion efficiency of a silicon solar cell becomes likely to lower. On the other hand, although the lower limit of the average particle diameter D₅₀ of the glass powders is not particularly limited, when the average particle diameter D₅₀ of the glass powders is too small, the ease of handling the glass powders and the material yield of the glass powders are liable to lower. When the circumstances described above are taken into consideration, the average particle diameter D₅₀ of the glass powders is preferably 0.1 µm or more. Note that (1) when a glass film is pulverized in a ball mill and the resultant glass powder is then subjected to air classification, or (2) when a glass film is roughly pulverized in a ball mill or the like and the resultant glass is then subjected to wet pulverization in a bead mill or the like, glass powders having the above-mentioned average particle diameter D₅₀ can be produced.

In the electrode formation material of the present invention, the maximum particle diameter Dₘₐₓ of the glass powders is 25 µm or less, 20 µm or less, 15 µm or less, 10 µm or less, or particularly preferably less than 10 µm. When the maximum particle diameter Dₘₐₓ of the glass powders is more than 25 µm, forming a fine electrode pattern becomes difficult, and hence the photoelectric conversion efficiency of the silicon solar cell becomes likely to lower. Here, the phrase "average particle diameter Dₘₐₓ" refers to a particle diameter at which the cumulative amount of particles starting from a particle having the smallest diameter reaches 99% in a cumulative particle size distribution curve in terms of volume prepared based on the measurements by laser diffractometry.

In the electrode formation material of the present invention, the softening point of the glass powder is 600°C or less, 570°C or less, or particularly preferably 560°C. When the softening point of the glass powder is more than 600°C, the region of the temperatures necessary for forming the electrodes rises, and hence the production efficiency of the silicon solar cell lowers.

In the electrode formation material of the present invention, the crystallization temperature of the glass powder is 500°C or more, 520°C or more, or particularly preferably 540°C or more. When the crystallization temperature of the glass powder is less than 500°C, the thermal stability of the glass powder lowers. As a result, when the electrode formation material is fired, glass becomes likely to devitrify and the mechanical strength of the back-surface electrode becomes likely to lower. Further, when glass devitrifies at low temperatures, promoting the reaction between an Al powder and Si becomes difficult and providing the BSF effect becomes difficult. Here, the phrase "crystallization temperature" refers to a peak temperature measured with a macro-type DTA apparatus, and in the DTA, the measurement starts from room temperature and the temperature rise rate is set to 10°C/min.

In the electrode formation material of the present invention, the content of the glass powder is 0.2 to 10 mass%, 0.5 to 6 mass%, 0.7 to 4 mass%, or particularly preferably 1 to 3 mass%. When the content of the glass powder is less than 0.2 mass%, promoting the reaction between an Al powder and Si becomes difficult, and moreover, the mechanical strength of the back-surface electrode is liable to lower. On the other hand, when the content of the glass powder is more than 10 mass%, segregation of glass becomes likely to occur after the firing of the electrode formation material and the conductivity of the back-surface electrode lowers. As a result, the photoelectric conversion efficiency of the silicon solar cell may lower. Further, because of the same reasons as those described above, the mass ratio of the content between the glass powder and the metal powder is 0.3:99.7 to 13:87, 1.5:98.5 to 7:93, or particularly preferably 1.8:98.2 to 4:96.

In the electrode formation material of the present invention, the content of the metal powder is 50 to 97 mass%, 65 to 95 mass%, or particularly preferably 70 to 92 mass%. When the content of the metal powder is less than 50 mass%, the conductivity oftheback-surfaceelectrode lowers. As a result, the photoelectric conversion efficiency of the silicon solar cell becomes likely to lower. On the other hand, when the content of the metal powder is more than 97 mass%, there is no other way but to relatively lower the content of the glass powder or vehicle, and hence it becomes difficult to form the p+ electrolytic layer.

In the electrode formation material of the present invention, the metal powder preferably includes one kind of powder or two or more kinds of powders of Ag, Al, Au, Cu, Pd, Pt, and alloys thereof. The powder of Al is particularly preferred from the viewpoint of providing the BSF effect. Any of those metal powders has good conductivity and has good compatibility with the glass powder according to the present invention. When any of those metal powders is used, glass thus becomes unlikely to devitrify, and moreover, glass becomes unlikely to produce bubbles during firing of electrode formation material. Further, in order to form a fine electrode pattern, the average particle diameter D₅₀ of the metal powders is 5 µm or less, 3 µm or less, 2 µm or less, or particularly preferably 1 µm or less.

In the electrode formation material of the present invention, the content of the vehicle is 5 to 50 mass% or particularly preferably 10 to 30 mass%. When the content of the vehicle is less than 5 mass%, converting the electrode formation material into a paste state becomes difficult, and hence it becomes difficult to form the electrodes by a thick-film method. On the other hand, when the content of the vehicle is more than 50 mass%, film thickness and filmwidth are liable to varybefore and after firing the electrode formation material. As a result, it becomes difficult to form a desired electrode pattern.

As described above, the term "vehicle" generally refers to a substance obtained by dissolving a resin in an organic solvent. Examples of the resin which may be used include an acrylic acid ester (acrylic resin), ethylcellulose, a polyethylene glycol derivative, nitrocellulose, polymethylstyrene, polyethylene carbonate, and a methacrylic acid ester. In particular, an acrylic acidester, nitrocellulose, and ethylcellulose are preferred because of good thermolytic property. Examples of the organic solvent which may be used include N,N'-dimethylformamide (DMF), α-terpineol, a higher alcohol, γ-butyrolactone (γ-BL), tetralin, butyl carbitol acetate, ethyl acetate, isoamyl acetate, diethylene glycol monoethyl ether, diethylene glycol monoethyl ether acetate, benzyl alcohol, toluene, 3-methoxy-3-methylbutanol, water, triethylene glycol monomethyl ether, triethylene glycol dimethyl ether, dipropylene glycol monomethyl ether, dipropylene glycol monobutyl ether, tripropylene glycol monomethyl ether, tripropylene glycol monobutyl ether, propylene carbonate, dimethyl sulfoxide (DMSO), and N-methyl-2-pyrrolidone. In particular, α-terpineol is preferred because of high viscosity and good solubility for a resin and the like.

The electrode formation material of the present invention may contain, in addition to the above-mentioned components, a ceramic filler powder such as cordierite for adjusting the thermal expansion coefficient, an oxide powder such as an NiO powder for adjusting the resistance of the surfaces of the electrodes, a surfactant, a thickener, a plasticizer, or a surface treating agent for adjusting the paste characteristic, a pigment for adjusting the color tone, and the like.

The electrode formation material (glass composition for electrode formation) of the present invention is suitable for forming not only the back-surface electrode but also the light-receiving surface electrode. When the light-receiving surface electrode is formed by a thick-film method, the phenomenon that the electrode formation material penetrates the anti-reflectivefilm duringfiring is taken advantage of to electrically connect the light-receiving surface electrode with a semiconductor layer. The phenomenon is generally called fire through. By taking advantage of the fire through, it becomes unnecessary to etch the anti-reflective film, and moreover, it becomes unnecessary to position an etching on the anti-reflective film with an electrode pattern, when the light-receiving surface electrode is formed. As a result, the production efficiency of the silicon solar cell improves dramatically. The degree of how much the electrode formation material penetrates the anti-reflective film (hereinafter, referred to as fire through property) varies depending on the composition of the electrode formation material and a firing condition, and in particular, is influenced most significantly by the glass composition of the glass powder. In addition, the photoelectric conversion efficiency of the silicon solar cell has a correlation with the fire through property of the electrode formation material. When the fire through property is poor, the characteristics lower. As a result, the fundamental performance of the solar cell lowers. In the electrode formation material of the present invention, the glass composition range of the glass powder is controlled in a predetermined range, and hence the electrode formation material has good fire through property and is suitable for forming the light-receiving surface electrode. When the electrode formation material of the present invention is used for forming the light-receiving surface electrode, an Ag powder is preferably used as the metal powder. The content or the like of the Ag powder is as described above.

The light-receiving surface electrode and the back-surface electrode may be formed separately, or the light-receiving surface electrode and the back-surface electrode may be simultaneously formed. When the light-receiving surface electrode and the back-surface electrode are simultaneously formed, the number of firing can be reduced, and hence the production efficiency of the solar cell is improved. Here, when the electrode formation material of the present invention is used for both the light-receiving surface electrode and the back-surface electrode, it becomes easy to form the light-receiving surface electrode and the back-surface electrode at the same time.

### Example 1

Hereinafter, the present invention is described in detail based on examples.

Tables 1 to 4 show examples (Sample Nos. 1 to 21) and comparative examples (Sample Nos. 22 to 24) of the present invention.

**[Table 1]**

| | | Example | | | | | |
|---|---|---|---|---|---|---|---|
| | | No. 1 | No. 2 | No. 3 | No. 4 | No. 5 | No. 6 |
| Glass composition (mass%) | Bi₂O₃ | 75.6 | 81.0 | 76.4 | 74.3 | 82.8 | 77.0 |
| | B₂O₃ | 9.3 | 9.0 | 8.1 | 10.1 | 5.5 | 9.0 |
| | ZnO | 11.0 | 7.0 | 6.4 | 8.0 | 10.4 | 11.0 |
| | SiO₂ | - | - | - | 0.8 | - | - |
| | Al₂O₃ | 1.0 | - | - | - | 0.5 | - |
| | CuO | 1.6 | 1.5 | 2.2 | 2.1 | - | - |
| | Fe₂O₃ | 0.5 | 0.5 | 0.5 | 0.5 | 0.2 | 0.4 |
| | BaO | 1.0 | 0.5 | 5.8 | 4.2 | 0.2 | 2.0 |
| | Sb₂O₃ | - | - | 0.6 | - | - | 0.6 |
| | Nd₂O₃ | - | 0.5 | - | - | 0.4 | - |
| Average particle diameter D₅₀ (µm) | | 2.0 | 2.0 | 2.0 | 2.0 | 2.0 | 1.0 |
| Glass transition point (°C) | | 373 | 350 | 357 | 384 | 346 | 375 |
| Softening point (°C) | | 441 | 415 | 424 | 451 | 414 | 445 |
| Crystallization temperature (°C) | | >700 | 605 | >700 | >700 | 617 | 579 |
| Metal powder | | Ag | Ag | Ag | Ag | Ag | Ag |
| Fire through property | | ○ | ○ | ○ | ○ | ○ | ○ |
| Water resistance | | ○ | ○ | ○ | ○ | ○ | ○ |

**[Table 2]**

| | | Example | | | | | |
|---|---|---|---|---|---|---|---|
| | | No. 7 | No. 8 | No. 9 | No. 10 | No. 11 | No. 12 |
| Glass composition (mass%) | Bi₂O₃ | 79.0 | 76.9 | 76.0 | 83.2 | 77.0 | 81.1 |
| | B₂O₃ | 8.5 | 7.8 | 8.0 | 9.5 | 8.0 | 9.8 |
| | ZnO | 7.5 | 9.5 | 11.0 | 4.9 | 11.5 | 4.9 |
| | SiO₂ | - | - | - | - | - | 0.4 |
| | Al₂O₃ | - | - | - | - | - | 0.5 |
| | CuO | 2.0 | 2.0 | - | 1.0 | 2.0 | - |
| | Fe₂O₃ | 0.5 | 0.5 | 0.4 | 0.2 | 0.5 | - |
| | SrO | - | - | - | - | 1.0 | - |
| | BaO | 2.0 | 3.0 | 4.0 | 1.2 | - | 2.3 |
| | Sb₂O₃ | - | 0.3 | 0.6 | - | - | 0.5 |
| | CeO₂ | 0.5 | - | - | - | - | 0.5 |
| Average particle diameter D₅₀ (µm) | | 1.0 | 1.0 | 1.0 | 1.0 | 1.5 | 1.5 |
| Glass transition point (°C) | | 352 | 355 | 371 | 343 | 363 | 351 |
| Softeningpoint (°C) | | 415 | 418 | 439 | 413 | 430 | 425 |
| Crystallization temperature (°C) | | >700 | >700 | >700 | 620 | >700 | 633 |
| Metal powder | | Ag | Ag | Ag | Ag | Ag | Ag |
| Fire through property | | ○ | ○ | ○ | ○ | ○ | ○ |
| Water resistance | | ○ | ○ | ○ | ○ | ○ | ○ |

**[Table 3]**

| | | Example | | | | | |
|---|---|---|---|---|---|---|---|
| | | No. 13 | No. 14 | No. 15 | No. 16 | No. 17 | No. 18 |
| Glass composition (mass%) | Bi₂O₃ | 76.4 | 76.4 | 76.4 | 73.8 | 79.8 | 76.4 |
| | B₂O₃ | 8.1 | 8.1 | 8.1 | 10.3 | 8.1 | 8.1 |
| | ZnO | 6.4 | 6.4 | 6.4 | 4.9 | 3.0 | 3.0 |
| | CuO | 2.2 | 2.2 | 2.2 | 2.3 | 2.2 | 2.2 |
| | Fe₂O₃ | 0.5 | 0.5 | 0.5 | 0.5 | 0.5 | 0.5 |
| | BaO | 5.8 | 5.8 | 5.8 | 7.5 | 5.8 | 9.2 |
| | Sb₂O₃ | 0.6 | 0.6 | 0.6 | 0.7 | 0.6 | 0.6 |
| Average particle diameter D₅₀ (µm) | | 0.5 | 7.5 | 1.0 | 0.8 | 1.3 | 1.4 |
| Glass transition point (°C) | | 357 | 357 | 357 | 370 | 346 | 345 |
| Softeningpoint (°C) | | 411 | 433 | 418 | 451 | 425 | 428 |
| Crystallization temperature (°C) | | >700 | >700 | >700 | >700 | 605 | >700 |
| Metal powder | | Ag | Ag | Al | Ag | Ag | Ag |
| Fire through property | | ○ | Δ | ○ | ○ | ○ | ○ |
| Water resistance | | ○ | ○ | ○ | ○ | ○ | ○ |

**[Table 4]**

| | | Example | | | Comparative Example | | |
|---|---|---|---|---|---|---|---|
| | | No. 19 | No. 20 | No. 21 | No. 22 | No. 23 | No. 24 |
| Glass composition (mass%) | Bi₂O₃ | 76.4 | 83.0 | 73.8 | 55.0 | 65.1 | - |
| | B₂O₃ | 8.1 | 5.7 | 10.3 | 20.0 | 1.9 | 12.7 |
| | ZnO | 3.0 | 4.0 | 4.9 | - | 10.2 | - |
| | SiO₂ | - | - | - | 5.4 | 10.0 | 1.0 |
| | Al₂O₃ | - | - | - | - | 1.8 | 1.0 |
| | CuO | 5.7 | - | 2.3 | - | - | - |
| | Fe₂O₃ | 0.5 | - | 0.5 | - | - | - |
| | Na₂O | - | - | - | 5.0 | - | - |
| | CaO | - | 0.2 | - | - | 1.0 | - |
| | BaO | 5.8 | 6.0 | 8.2 | 4.5 | 10.0 | - |
| | Sb₂O₃ | 0.6 | - | - | - | - | - |
| | Nd₂O₃ | - | 0.3 | - | - | - | - |
| | CeO₂ | - | - | - | 0.1 | - | - |
| | PbO | - | - | - | 10.0 | - | 85.3 |
| Average particle diameter D₅₀ (µm) | | 1.4 | 0.8 | 0.8 | 2.0 | 2.0 | 2.0 |
| Glass transition point (°C) | | 337 | 350 | 370 | 391 | 438 | 312 |
| Softening point(°C) | | 433 | 422 | 452 | 482 | 507 | 358 |
| Crystallization temperature (°C) | | 623 | 651 | >700 | 490 | 588 | - |
| Metal powder | | Ag | Ag | Al | Ag | Ag | Ag |
| Fire through property | | ○ | ○ | ○ | × | × | ○ |
| Water resistance | | ○ | ○ | ○ | × | ○ | × |

Each sample was produced as described below. First, each glass batch was prepared by compounding glass materials such as various oxides and carbonates so as to have each of the glass compositions shown in the tables. The glass batch was loaded in a platinum crucible and melted at 900 to 1100°C for 1 to 2 hours. Next, part of the molten glass was extruded in a mold made of stainless steel to produce a sample for push-rod-type thermomechanical analysis (TMA). The remainder of the molten glass was formed into a film by using a water-cooling roller. The resultant glass film was pulverized in a ball mill, and the resultant pulverized glass was then passed though a sieve having a mesh size of 200 meshes. After that, air classification was carried out to yield glass powders having an average particle diameter D₅₀ of 2 µm.

Each resultant glass was measured for a glass transition point, a softening point, and a crystallization temperature.

The glass transition point is a value measured with a TMA apparatus.

The softening point and the crystallization temperature are values measured with a macro-type DTA apparatus. Note that the measurement temperature region was set to room temperature to 700°C and the temperature rise rate was set to 10°C/min.

Each of the resultant glass powders at 4 mass%, each of the metal powders (an average particle diameter D₅₀ of 0.5 µm) shown in the tables at 76 mass%, and a vehicle (substance obtained by dissolving an acrylic acid ester in α-terpineol) at 20 mass% were kneaded with a three-roll mill, thereby yielding each paste-like electrode formation material. The electrode formation material was evaluated for fire through property and water resistance.

The fire through property was evaluated as described below. Each sample was used to screen print a line on a SiN film (a thickness of 200 nm) formed on an Si substrate so that the line has a length of 200 mm and a width of 100 µm. After the sample was dried, the Si substrate was fired at 700°C for 1 minute in an electric furnace. Next, the resultant fired substrate was immersed in an aqueous solution of hydrochloric acid (a concentration of 10 wt%) . Then, ultrasonic treatment was carried for 12 hours to etch the each sample. The fired substrate after etching was observed with an optical microscope (a magnification of 100 times) to evaluate the fire through property. When a sample penetrated a SiN film and a linear electrode pattern was formed on a Si substrate, the sample was defined as "○" . When a linear electrode pattern was mostly formed on a Si substrate, but portions in which a sample did not penetrate a SiN film were present, and hence the electrical connection of the resultant electrode with the Si substrate was partially disconnected, the sample was defined as "Δ". When a sample did not penetrate a SiN film, the sample was defined as "×". The fire through property was evaluated based on the above criteria.

The water resistance was evaluated as described below. Each sample was used to screen print a line on a SiN film (a thickness of 200 nm) formed on a Si substrate so that the line has a length of 200 mm and a width of 100 µm. After the sample was dried, the substrate was fired at 700°C for 1 minute in an electric furnace. Next, the fired substrate was placed in a constant temperature and humidity chamber bath under a temperature of 90°C and a humidity of 95% for 2000 hours. After that, the electrical conductivity of an electrode was measured. When the electrical conductivity lowered by 60% or more after the constant temperature and humidity chamber test compared with an initial conductivity, a sample was defined as "×". When any other conductivity change was measured, a sample was defined as "○". The water resistance was evaluated based on the above criteria.

As evident from Tables 1 to 4, Sample Nos. 1 to 21 have good evaluations on fire through property and water resistance, and hence it is thought that Sample Nos. 1 to 21 can be suitably used in a silicon solar cell. On the other hand, Sample No. 22 had a glass composition out of a predetermined range and had poor evaluations on fire through property and water resistance. Sample No. 23 had glass composition out of a predetermined range and had a poor evaluation on fire through property. Sample No. 24 was conventional lead glass and had poor water resistance.

### Example 2

Hereinafter, the present invention is described in detail based on examples.

Tables 5 to 6 show examples (Sample Nos. 25 to 34) and comparative examples (Sample Nos. 35 to 37) of the present invention. Sample Nos. 35 and 36 are each an example of a conventional glass composition for electrode formation.

**[Table 5]**

| | | Example | | | | | | | |
|---|---|---|---|---|---|---|---|---|---|
| | | No. 25 | No. 26 | No. 27 | No. 28 | No. 29 | No. 30 | No. 31 | No. 32 |
| Glass composition (mass%) | Bi₂O₃ | 80 | 80 | 80 | 86 | 76.4 | 76.4 | 70 | 65 |
| | B₂O₃ | 15 | 15 | 15 | 7.5 | 11.6 | 14.5 | 19 | 22 |
| | ZnO | - | 0.5 | 2 | - | - | - | - | - |
| | CuO | 2 | 2 | 2 | 2 | 2.2 | 2 | 2 | 2 |
| | Fe₂O₃ | - | - | - | 0.5 | 0.5 | 0.5 | 0.5 | 0.5 |
| | Sb₂O₃ | - | - | - | 0.5 | 0.6 | - | - | - |
| | Nd₂O₃ | - | - | - | - | - | 0.6 | - | - |
| | SiO₂ | 2 | 0.9 | - | 1 | 2.5 | - | - | 7 |
| | Li₂O | - | - | 0.2 | - | 0.1 | - | - | - |
| | Na₂O | 0.2 | 0.2 | - | - | 0.2 | 0.2 | - | 1 |
| | K₂O | 0.3 | 0.3 | 0.3 | - | 0.1 | - | - | 1 |
| | MgO | - | - | - | 1 | - | - | - | - |
| | CaO | - | - | - | 0.5 | - | 5.8 | 1 | - |
| | BaO | - | 0.9 | - | - | 5.8 | - | 7.5 | - |
| | Al₂O₃ | 0.5 | 0.2 | 0.5 | 1 | - | - | - | 1.5 |
| α (×10⁻⁷/°C) | | 93 | 97 | 100 | 116 | 91 | 102 | 95 | 75 |
| Softening point (°C) | | 485 | 472 | 463 | 419 | 494 | 465 | 478 | 541 |
| Thermal stability | | ○ | ○ | ○ | ○ | ○ | ○ | ○ | ○ |
| Resistance of surface of p+ electrolytic layer | | ○ | ○ | ○ | ○ | ○ | ○ | ○ | ○ |
| Outer appearance | | ○ | ○ | ○ | ○ | ○ | ○ | ○ | ○ |
| Warpage | | ○ | ○ | ○ | ○ | ○ | ○ | ○ | ○ |
| Fire through property | | ○ | ○ | ○ | ○ | ○ | ○ | ○ | ○ |

**[Table 6]**

| | | Example | | Comparative Example | | |
|---|---|---|---|---|---|---|
| | | No. 33 | No. 34 | No. 35 | No. 36 | No. 37 |
| Glass composition (mass%) | Bi₂O₃ | 82 | 75 | 76.8 | - | 71 |
| | B₂O₃ | 10 | 15 | 11.5 | 30 | 9 |
| | ZnO | - | 0.5 | - | - | 11 |
| | CuO | - | 2 | - | - | - |
| | Fe₂O₃ | 0.5 | 0.5 | - | - | 0.5 |
| | Sb₂O₃ | - | - | - | - | 0.5 |
| | Nd₂O₃ | 2 | - | - | | - |
| | SiO₂ | - | - | 2.5 | 10 | - |
| | Li₂O | 0.1 | - | - | - | - |
| | Na₂O | 0.5 | 0.5 | - | - | - |
| | K₂O | 0.4 | - | - | - | - |
| | CaO | 1 | - | - | - | - |
| | SrO | - | - | - | - | 1 |
| | BaO | 3 | 6.5 | - | - | 7 |
| | CeO₂ | 0.5 | - | - | - | - |
| | PbO | - | - | 9.2 | 60 | - |
| α (×10⁻⁷/°C) | | 104 | 101 | 91 | 103 | 94 |
| Softening point (°C) | | 452 | 461 | 469 | 388 | 481 |
| Thermal stability | | ○ | ○ | ○ | ○ | ○ |
| Resistance of surface of p+ electrolytic layer | | ○ | ○ | Measurement was not performed | - | ○ |
| Outer appearance | | ○ | ○ | × | × | - |
| Warpage | | ○ | ○ | ○ | ○ | ○ |
| Fire through property | | ○ | ○ | Δ | × | Δ |

Each sample was produced as described below. First, each glass batch was prepared by compounding glass materials such as various oxides and carbonates so as to have each of the glass compositions shown in the tables. The glass batch was loaded in a platinum crucible and melted at 1100°C to 1200°C for 1 to 2 hours. Next, part of the molten glass was extruded in a mold made of stainless steel to produce a sample for TMA. The remainder of the molten glass was formed into a film by using a water-cooling roller. The resultant glass film was pulverized in a ball mill, and the resultant pulverized glass was then passed though a sieve having a mesh size of 250 meshes. After that, air classification was carried out to yield glass powders having an average particle diameter D₅₀ of 1.5 µm.

Each resultant glass was measured for a thermal expansion coefficient α, a softening point, and thermal stability.

The thermal expansion coefficient α is a value measured with a TMA apparatus and is a value measured in the temperature range of 30 to 300°C.

The softening point is a value measured with a macro-type DTA apparatus. Note that the measurement temperature region in macro-type DTAwas set to roomtemperature to 650°C and the temperature rise rate was set to 10°C/min.

When a glass sample had a crystallization temperature of 500°C or more, the thermal stability of the glass sample was defined as "○" . When a glass sample had a crystallization temperature of less than 500°C, the thermal stability of the glass sample was defined as "×". The thermal stability was evaluated based on the above criteria. Note that the crystallization temperature is a value measured with the macro-type DTA apparatus. The measurement temperature region in macro-type DTA was set to room temperature to 570°C and the temperature rise rate was set to 10°C/min.

Each of the resultant glass powders at 3 mass%, an Al powder (an average particle diameter D₅₀ of 0.5 µm) at 75 mass%, and a vehicle (substance obtained by dissolving an acrylic acid ester in α-terpineol) at 23 mass% were kneaded with a three-roll mill, thereby yielding each paste-like electrode formation material. Next, the each electrode formation material was applied onto the whole back surface of a silicon semiconductor substrate (100 mm by 100 mm by 200 µm in thickness) by screen printing, followed by drying. After that, the silicon semiconductor substrate was fired at the maximum temperature of 720°C for a short time (for 2 minutes from the start of the firing to the finish and the maximum temperature was kept for 10 seconds), yielding each back-surface electrode having a thickness of 50 µm. The resultant back-surface electrode was evaluated for the resistance of the surface of a p+ electrolytic layer, outer appearance, and warpage.

The resistance value of the surface of the p+ electrolytic layer which was produced by using Sample No. 36 was defined as the standard. The case where the resistance value of the surface of a p+ electrolytic layer was equal to or less than the standard was defined as "○" . The case where the resistance value of the surface of a p+ electrolytic layer was larger than the standard was defined as "×". The resistance value of the surface of the p+ electrolytic layer was evaluated based on the above criteria. Note that as the resistance value of the surface of the p+ electrolytic layer is lower, a BFS effect becomes likely to be provided.

The outer appearance was evaluated by examining the numbers of blisters and aggregations of Al through visual observation of the surface of the back-surface electrode. The case where the numbers of blisters and aggregations of Al were smaller than those on the back-surface electrode produced by using Sample No. 37 was defined as "○". The case where the numbers of blisters and aggregations of Al were larger than those on the back-surface electrode produced by using Sample No. 37 was defined as "×".

The warpage was evaluated by measuring the surface of the light-receiving surface side of the silicon semiconductor substrate with a contact-type surface roughness meter. In the central portion of the silicon semiconductor substrate, the warpage was measured at an interval of 30 mm. The case where the difference in height between the lowermost part and the uppermost part was less than 20 µm was defined as "○". The case where the difference was 20 µm or more was defined as "×".

As evident from Tables 5 and 6, Sample Nos. 25 to 34 had good evaluations on the resistance of the surface of a p+ electrolytic layer, the outer appearance, and the warpage. On the other hand, Sample No. 35 had poor evaluations on the resistance of the surface of a p+ electrolytic layer and the outer appearance. Sample No. 36 had poor evaluation on the outer appearance. Sample No. 37 was inferior to Samples No. 25 to 34 in the evaluations on the outer appearance.

### Example 3

Sample Nos. 25 to 37 were evaluated for fire through property. The fire through property was evaluated as described below. Each electrode formation material was used to screen print a line on a SiN film (a thickness of 100 nm) formed on a silicon semiconductor substrate so that the line has a length of 200 mm and a width of 100 µm. After the electrode formation material was dried, the silicon semiconductor substrate was fired at the maximum temperature of 720°C for a short time (for 2 minutes from the start of the firing to the finish and the maximum temperature was kept for 10 seconds) . Next, the fired silicon semiconductor substrate was immersed in an aqueous solution of hydrochloric acid (a concentration of 10 wt%) . Then, ultrasonic treatment was carried out for 12 hours to etch the each sample. The silicon semiconductor substrate after etching was observed with an optical microscope (a magnification of 100 times) to evaluate the fire through property. When a sample penetrated a SiN film and a linear electrode pattern was formed on a silicon semiconductor substrate, the sample was defined as "○". When a linear electrode pattern was mostly formed on a silicon semiconductor substrate, but portions in which a sample did not penetrate a SiN film were present, and hence the electrical connection of the resultant electrode with the silicon semiconductor substrate was partially disconnected, the sample was defined as "Δ". When a sample did not penetrate a SiN film, the sample was defined as "×". The fire through property was evaluated based on the above criteria. As a result, Sample Nos. 25 to 34 were evaluated as "○" and had good fire through property. Thus, it is thought that Sample Nos. 25 to 34 were suitable for forming the light-receiving surface electrode of the silicon solar cell. On the other hand, Sample Nos. 35 and 37 were evaluated as "Δ" and had poor fire through property. Further, Sample No. 36 was evaluated as "×" and had poor fire through property.

### Industrial Applicability

The glass composition for electrode formation and electrode formation material of the present invention can be, as described above, suitably used for the electrodes of a silicon solar cell. Further, the glass composition for electrode formation and electrode formation material of the present invention can be applied to ceramic electronic parts such as a ceramic condenser and optical parts such as a photodiode.

## Claims

1. A glass composition for electrode formation, comprising, as a glass composition expressed in terms of oxides by mass%, 73.1 to 90% of Bi₂O₃, 2 to 14.5% of B₂O₃, 0 to 25% of ZnO, 0.2 to 20% of MgO+CaO+SrO+BaO, and 0 to 8.5% of SiO₂+Al₂O₃.

2. The glass composition for electrode formation according to claim 1, wherein a content of Bi₂O₃ is 74.3% or more.

3. The glass composition for electrode formation according to claim 1 or 2, wherein a content of BaO is 0.2 to 15%.

4. The glass composition for electrode formation according to any one of claims 1 to 3, wherein the glass composition includes 2.5% or less of CuO.

5. An electrode formation material, comprising a glass powder including the glass composition for electrode formation according to any one of claims 1 to 4, a metal powder, and a vehicle.

6. The electrode formation material according to claim 5, wherein the glass powder has an average particle diameter D₅₀ of less than 5 µm.

7. The electrode formation material according to claim 5 or 6, wherein the glass powder has a softening point of 500°C or less.

8. The electrode formation material according to any one of claims 5 to 7, wherein the glass powder has a crystallization temperature of 500°C or more.

9. The electrode formation material according to any one of claims 5 to 8, wherein a content of the glass powder is 0.2 to 10 mass%.

10. The electrode formation material according to any one of claims 5 to 9, wherein the metal powder comprises one kind of powder or two or more kinds of powders of Ag, Al, Au, Cu, Pd, Pt, and alloys thereof.

11. The electrode formation material according to any one of claims 5 to 10, wherein the electrode formation material is used for an electrode of a silicon solar cell.

12. The electrode formation material according to any one of claims 5 to 11, wherein the electrode formation material is used for a light-receiving surface electrode of a silicon solar cell having an anti-reflective film.

13. A glass composition for electrode formation, comprising, as a glass composition expressed in terms of oxides by mass%, 60 to 90% of Bi₂O₃, 2 to 30% of B₂O₃, 0 to less than 3% of ZnO, and 0.1 to 15% of CuO+Fe₂O₃+Sb₂O₃+Nd₂O₃.

14. The glass composition for electrode formation according to claim 13, wherein a content of ZnO is less than 1%.

15. The glass composition for electrode formation according to claim 13 or 14, wherein the glass composition for electrode formation is substantially free of ZnO.

16. The glass composition for electrode formation according to any one of claims 13 to 15, comprising 0.05% or more of alkali metal oxides.

17. The glass composition for electrode formation according to any one of claims 13 to 16, comprising less than 3% of SiO₂.

18. An electrode formation material, comprising a glass powder including the glass composition for electrode formation according to any one of claims 13 to 17, a metal powder, and a vehicle.

19. The electrode formation material according to claim 18, wherein the glass powder has an average particle diameter D₅₀ of less than 5 µm.

20. The electrode formation material according to claim 18 or 19, wherein the glass powder has a softening point of 600°C or less.

21. The electrode formation material according to any one of claims 18 to 20, wherein a content of the glass powder is 0.2 to 10 mass%.

22. The electrode formation material according to any one of claims 18 to 21, wherein the metal powder comprises one kind of powder or two or more kinds of powders of Ag, Al, Au, Cu, Pd, Pt, and alloys thereof.

23. The electrode formation material according to any one of claims 18 to 22, wherein the metal powder comprises an Al powder.

24. The electrode formation material according to any one of claims 18 to 23, wherein the electrode formation material is used for an electrode of a silicon solar cell.

25. The electrode formation material according to any one of claims 18 to 24, wherein the electrode formation material is used for a back-surface electrode of a silicon solar cell.
